# FASCICULE DE BREVET EUROPEEN

(11) **EP 0 535 013 B1**
(45) Date de publication et mention de la délivrance du brevet: **04.05.1994**
(21) Numéro de dépôt: 91910301.0
(22) Date de dépôt: 12.06.1991
(51) Int. Cl.: B01D 9/02, B01D 9/00

(54) **PROCEDE ET INSTALLATION POUR LA CRISTALLISATION D'UNE SUBSTANCE MINERALE**
VERFAHREN UND VORRICHTUNG ZUM KRISTALLISIEREN EINES MINERALS
METHOD AND APPARATUS FOR CRYSTALLIZING A MINERAL SUBSTANCE

(30) Priorité: 22.06.1990 BE 9000645
(43) Date de publication de la demande: 07.04.1993
(73) Titulaire: SOLVAY, B-1050 Bruxelles (BE)
(72) Inventeur: DARMONT, Jacques, B-1050 Bruxelles (BE); DETRY, Léopold, B-1300 Wavre (BE)
(74) Mandataire: Anthoine, Paul
(86) Numéro de dépôt international: BE9100037
(87) Numéro de publication internationale: WO9200130

(56) Documents cités:
- EP-A- 352 847
- FR-A- 648 701
- FR-A- 2 561 125

## Description

La présente invention concerne un procédé pour la cristallisation d'une substance minérale, mettant en oeuvre un lit de cristaux traversé par une solution sursaturée en la substance à cristalliser.

Le cristalliseur "OSLO" est un appareil bien connu pour la cristallisation de substances minérales (British Chemical Engineering, August 1971, Vol. 16, No. 8, pages 681 à 685; The Chemical Engineer, July/August 1974, pages 443 à 445; brevet britannique GB-A-418349). Cet appareil connu comprend une cuve cylindrique verticale et un tube vertical qui est disposé axialement dans la cuve et débouche au voisinage immédiat du fond de celle-ci; une chambre annulaire verticale est ainsi délimitée entre le tube axial et la paroi cylindrique de la cuve. Dans l'exploitation de cet appareil connu, on met en oeuvre, dans la chambre annulaire, un lit de cristaux que l'on fait traverser par une solution sursaturée en la substance que l'on souhaite cristalliser (par exemple une solution aqueuse sursaturée de chlorure de sodium). Cette solution est introduite dans l'appareil via le tube axial, de manière qu'elle pénètre radialement dans la chambre annulaire, près du fond de celle-ci et soumette les cristaux du lit à une rotation d'ensemble comprenant une translation ascendante le long de la paroi de la cuve et une translation descendante le long du tube axial.

Dans cet appareil connu, on vise à produire des grains cristallins réguliers de forme sphérique, dont le diamètre moyen devrait pouvoir être réglé par un choix approprié des dimensions de l'appareil et des conditions opératoires. En pratique toutefois, cet appareil connu est mal adapté à l'obtention de gros grains sphériques, du fait notamment de l'attrition générée au sein du lit de cristaux et de la rotation d'ensemble à laquelle ceux-ci sont soumis.

Dans le document EP-A-0352847 (SOLVAY & Cie), on décrit un procédé et une installation qui remédient aux inconvénients précités. Dans ce procédé et cette installation, on met en oeuvre un réacteur à lit fluidisé et on fait circuler la solution sursaturée en la substance à cristalliser, de bas en haut à travers un distributeur de manière à générer au-dessus de celui-ci le lit fluidisé de cristaux; on recueille au-dessus du lit l'eau mère de la cristallisation et on la recycle en amont du lit après l'avoir sursaturée pour reconstituer la solution sursaturée de départ.

L'invention perfectionne le procédé et l'installation du document EP-A-0352847, en fournissant un moyen qui réduit le risque d'une formation parasite de cristaux sous le lit fluidisé.

L'invention concerne dès lors un procédé pour la cristallisation d'une substance minérale dans un lit fluidisé de cristaux, que l'on génère en soumettant une solution sursaturée en la substance à cristalliser, à une circulation ascendante à travers un distributeur de réacteur à lit fluidisé, situé sous le lit, on recueille l'eau mère de la cristallisation à la sortie du lit et on la sursature pour reconstituer la solution sursaturée précitée; selon l'invention, on dérive une fraction de la solution sursaturée en amont du distributeur et on la recycle en aval du distributeur, avant de recueillir l'eau mère.

Dans le procédé selon l'invention, les cristaux du lit servent de germes pour la cristallisation de la matière minérale par désursaturation de la solution sursaturée. Ils sont généralement de petits cristaux réguliers de la substance minérale que l'on vise à cristalliser.

Le taux de sursaturation de la solution sursaturée dépend de divers paramètres, notamment de la nature de la matière minérale, de sa température et de la présence éventuelle d'impuretés solides ou dissoutes. En pratique, toutes autres choses égales, on a intérêt à réaliser un taux de sursaturation maximum, celui-ci devant toutefois être limité pour éviter des cristallisations accidentelles sur les parois de l'installation de cristallisation, en amont du lit de cristaux, ainsi que des germinations primaires et secondaires au sein de la solution.

Le solvant de la solution n'est pas critique, et l'eau est généralement préférée.

La température de la solution sursaturée n'est pas critique. On a toutefois observé, en pratique, que la vitesse de croissance des cristaux du lit est d'autant plus grande que la température de la solution est élevée. Il convient toutefois que la température de la solution reste inférieure à sa température d'ébullition à la pression régnant dans la chambre de cristallisation. Par exemple, dans le cas où le procédé est appliqué à la cristallisation de chlorure de sodium, on peut avantageusement mettre en oeuvre des solutions aqueuses de chlorure de sodium présentant un degré de sursaturation compris entre 0,3 et 0,5 g/kg, à une température comprise entre 50 et 110°C. Le degré de sursaturation exprime la masse de matière minérale en excès par rapport à la masse correspondant à la saturation de la solution.

Le lit de cristaux est un lit fluidisé, conformément à la définition généralement admise (Givaudon, Massot et Bensimon - "Précis de génie chimique" - Tome 1 - Berger-Levrault, Nancy - 1960, pages 353 à 370). Pour fluidiser le lit, on fait passer le courant de la solution sursaturée dans un distributeur disposé sous le lit de cristaux, conformément à la technique habituelle des réacteurs à lit fluidisé. Le distributeur est un organe fondamental des réacteurs à lit fluidisé. Il a pour fonction de diviser le courant de solution en filets, de préférence parallèles et verticaux, en lui imposant par ailleurs une perte de charge définie, réglée en fonction des dimensions du lit, de la nature des particules formant le lit et de la solution (Ind. Eng. Chem. Fundam. - 1980 - 19 - G.P. Agarwal et consorts - "Fluid mechanical description of fluidized beds. Experimental investigation of convective instabilities in bounded beds" - pages 59 à 66; John H. Perry - Chemical Engineers' Handbook - 4e édition - 1963 - McGraw-Hill book company - pages 20.43 à 20 46). Il peut par exemple être une plaque horizontale percée d'orifices régulièrement répartis, une grille ou un treillis horizontal, ou un assemblage de buses verticales.

En aval du lit de cristaux, on recueille l'eau mère de la cristallisation. Celle-ci est une solution saturée en la substance à cristalliser. On la traite pour l'amener dans un état de sursaturation, puis on la recycle dans la solution sursaturée en amont du distributeur. Le moyen mis en oeuvre pour obtenir la sursaturation de l'eau mère n'est pas critique. La sursaturation de l'eau mère peut par exemple être obtenue en modifiant sa température ou en la soumettant à une évaporation partielle.

Des détails concernant la mise en oeuvre du lit fluidisé, la solution sursaturée, le recyclage de l'eau mère et la régénération de la solution sursaturée sont décrits dans le document EP-A-0352847 (SOLVAY & Cie).

Selon l'invention, on dérive une fraction de la solution sursaturée en amont du distributeur et on la recycle en aval du distributeur, avant de sursaturer l'eau mère de la cristallisation. La fraction dérivée de solution sursaturée a pour fonction d'évacuer les éventuels cristaux parasites qui viendraient à s'accumuler ou se former sous le distributeur à la suite d'une désursaturation partielle intempestive de la solution sursaturée. La dérivation de la fraction de solution sursaturée est dès lors exécutée dans une zone de la solution sursaturée, où existe un risque d'une cristallisation parasite. Une zone propice pour le prélèvement de la fraction de solution sursaturée est localisée le long des parois de l'appareil de cristallisation, sous le distributeur.

Le recyclage de la fraction dérivée de solution sursaturée doit être exécuté avant de sursaturer l'eau mère. Ladite fraction peut par exemple être recyclée dans le lit fluidisé ou dans l'eau mère en aval du lit fluidisé.

Le débit relatif de la fraction dérivée de solution sursaturée par rapport au débit de solution sursaturée traversant le distributeur du lit fluidisé dépend de divers paramètres, parmi lesquels figurent notamment la nature de la substance à cristalliser, le degré de sursaturation, la température de travail et les caractéristiques constructives de l'installation utilisée. Il doit être déterminé dans chaque cas particulier. En général, dans la majorité des cas, on obtient de bons résultats en choisissant pour la fraction dérivée de solution sursaturée un débit au moins égal à 1 % du débit de solution sursaturée traversant le distributeur. On n'a pas intérêt à choisir une valeur excessive pour le débit relatif de la fraction dérivée de solution sursaturée, sous peine de déstabiliser le lit fluidisé. Des valeurs comprises entre 1 et 10 % conviennent généralement bien pour le rapport entre le débit de la fraction dérivée de solution sursaturée et le débit de solution sursaturée traversant le distributeur du lit fluidisé.

La dérivation de la fraction de solution sursaturée et son recyclage peuvent être opérés par tous moyens connus. Un moyen commode consiste à utiliser un tuyau dont une extrémité débouche dans la solution sursaturée en amont du distributeur et dont l'autre extrémité débouche en aval du distributeur, et à conférer au tuyau une section appropriée en fonction du débit imposé à la fraction dérivée de solution sursaturée. Dans cette forme de réalisation de l'invention, il est important d'éviter une cristallisation intempestive dans le tuyau, par désursaturation partielle accidentelle de la fraction dérivée de solution sursaturée. A cet effet, il convient de calorifuger convenablement le tuyau et de chauffer sa paroi. Dans une forme de réalisation avantageuse du procédé selon l'invention, on utilise un tuyau qui traverse le distributeur et une partie au moins du lit fluidisé de cristaux. Dans cette forme de réalisation de l'invention, la paroi du tuyau est maintenue en permanence à la température du lit et de la solution sursaturée, ce qui réduit le risque d'une cristallisation accidentelle dans le tuyau.

L'invention concerne aussi une installation pour la cristallisation d'une substance minérale au moyen d'un procédé conforme à l'invention, ladite installation comprenant une enceinte tubulaire verticale, un tube vertical disposé axialement dans l'enceinte tubulaire et débouchant à proximité du fond de celle-ci de manière à délimiter une chambre annulaire dans l'enceinte, un dispositif d'alimentation d'une solution sursaturée en la substance à cristalliser, raccordé à l'extrémité supérieure du tube, un distributeur de réacteur à lit fluidisé dans la chambre annulaire qu'il divise en une chambre inférieure d'admission de la solution sursaturée et une chambre supérieure de cristallisation constituant le réacteur à lit fluidisé, et un conduit d'évacuation d'une eau mère de la cristallisation, joignant la chambre de cristallisation au dispositif d'alimentation, ladite installation comprenant en outre au moins un tuyau joignant la chambre inférieure d'admission à la chambre supérieur de cristallisation.

Dans une forme de réalisation particulière de l'installation selon l'invention, le distributeur est muni d'un thermostat qui a pour fonction de maintenir le distributeur à une température uniforme, réglée en fonction de celle de la solution sursaturée mise en oeuvre, pour éviter une cristallisation spontanée de la substance minérale, au contact du distributeur. Le thermostat peut dès lors comprendre un moyen de chauffage ou un moyen de refroidissement du distributeur, selon que l'installation est destinée au traitement de solutions sursaturées de substances minérales dont la solubilité est une fonction croissante ou une fonction décroissante de la température. Des particularités et détails concernant le distributeur du lit fluidisé sont décrits dans le document EP-A-0352847 (SOLVAY & Cie).

Dans l'installation selon l'invention, la section transversale du tuyau est réglée pour que, pendant le fonctionnement de l'installation, il circule dans le tuyau un débit de solution sursaturée qui soit égal à une fraction définie, prédéterminée du débit de solution sursaturée qui traverse le distributeur. Le tuyau peut être disposé à l'extérieur de l'enceinte tubulaire. Le cas échéant, il est généralement nécessaire de le calorifuger et de chauffer sa paroi pour éviter une désursaturation de la fraction de solution sursaturée qui y circule pendant le fonctionnement de l'installation.

Dans une forme de réalisation préférée de l'installation selon l'invention, le tuyau est disposé à l'intérieur de la chambre annulaire et il traverse le distributeur. Cette forme de réalisation de l'invention présente l'avantage que le tuyau est maintenu en permanence à la température du lit de cristaux pendant le fonctionnement de l'installation. On réduit ainsi le risque d'une cristallisation accidentelle dans le tuyau.

Le procédé et l'installation selon l'invention permettent de cristalliser une substance minérale à l'état de grains réguliers de forme approximativement sphérique. Ceux-ci sont généralement des billes monolithiques, ce qui signifie qu'elles sont des blocs unitaires, non agglomérés, de la matière minérale. Le procédé et l'installation selon l'invention trouvent une application spécialement avantageuse pour la production de cristaux de chlorure de sodium à l'état de billes sphériques monolithiques dont le diamètre est supérieur à 3 mm, par exemple compris entre 3 et 30 mm. Des cristaux de chlorure de sodium de diamètre compris entre 5 et 10 mm trouvent une application intéressante pour la production de sel à l'état de grains irréguliers et d'aspect translucide et vitreux par la technique décrite dans le document EP-A-162490 (SOLVAY & Cie).

Des particularités et détails de l'invention vont ressortir de la description suivante, en référence aux dessins annexés.
La figure 1 représente, en section transversale verticale, une forme de réalisation particulière de l'installation selon l'invention;
La figure 2 est une vue analogue à la figure 1 d'une seconde forme de réalisation de l'installation selon l'invention;
La figure 3 est une vue analogue à la figure 1 d'une forme de réalisation préférée de l'installation selon l'invention.

Dans ces figures, les mêmes notation de référence désignent des éléments identiques.

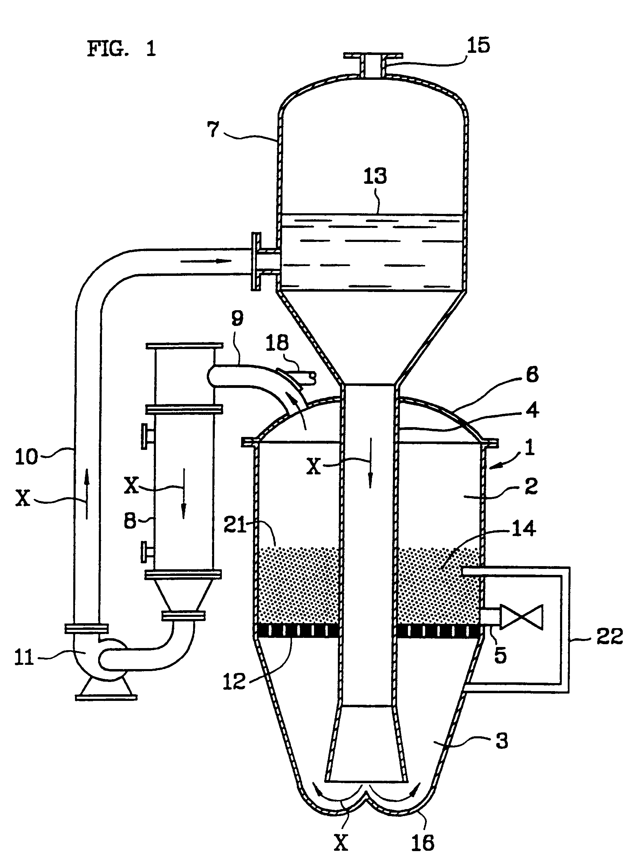

L'installation représentée à la figure 1 est un cristalliseur du type de celui décrit dans le document EP-A-0352847 (SOLVAY & Cie) et modifié conformément à la présente invention. Il comprend une enceinte tubulaire verticale 1 dans laquelle un tube vertical 4, dont la partie inférieure est évasée, est disposé axialement. Le tube 4 délimite ainsi dans l'enceinte 1 une chambre annulaire comprenant une zone supérieure cylindrique 2 et une zone inférieure tronconique 3 dont le fond 16 a le profil d'une surface torique autour d'un cône central axial. L'enceinte 1 est obturée par un couvercle 6 traversé par le tube 4 qui débouche dans une chambre de détente 7. Un réchauffeur 8 est interposé entre le ciel de la zone supérieure 2 et la chambre de détente 7, via des conduits 9 et 10 et une pompe de circulation 11.

La zone supérieure 2 est destinée à contenir un lit de cristaux 14 et à être exploitée comme un réacteur à lit fluidisé. A cet effet, elle est séparée de la zone inférieure 3 par un distributeur 12 de réacteur à lit fluidisé. Dans l'installation de la figure 1, la zone supérieure annulaire 2 constitue une chambre de cristallisation et la zone inférieure annulaire 3 sert de chambre d'admission d'une solution sursaturée en une substance minérale que l'on souhaite cristalliser.

Conformément à l'invention, un tuyau 22 relie les deux chambres annulaires 2 et 3.

L'installation représentée à la figure 1 convient notamment pour la cristallisation de chlorure de sodium à l'état de billes sphériques. A cet effet, l'installation est remplie d'une solution aqueuse de chlorure de sodium jusqu'au niveau 13, dans la chambre de détente 7, de manière que la chambre de cristallisation 2 soit noyée. Celle-ci contient par ailleurs un lit de cristaux de chlorure de sodium 14, au-dessus du distributeur 12.

Pendant le fonctionnement de l'installation, la solution aqueuse de chlorure de sodium est mise à circuler dans le sens des flèches X par la pompe 11. A la sortie de la chambre 2, via le conduit 9, la solution saturée en chlorure de sodium traverse le réchauffeur 8, ce qui élève sa température, puis pénètre dans la chambre de détente 7, où elle est partiellement vaporisée par détente, ce qui provoque son refroidissement et sa sursaturation. La vapeur d'eau libérée est évacuée par un orifice supérieur 15 de la chambre de détente 7. La solution aqueuse sursaturée descend verticalement dans le tube 4 et pénètre radialement dans la chambre 3, le long du fond torique 16. Dans la chambre 1, la solution sursaturée se répartit en deux courants distincts : un courant principal traverse le distributeur 12 et pénètre dans le lit de cristaux 14 qu'il fluidise; simultanément un courant de plus faible débit est dérivé par le tuyau 22 et recyclé dans le lit fluidisé 14 où il rejoint le courant principal. La solution sursaturée est progressivement désursaturée pendant qu'elle traverse le lit fluidisé 14, dont les cristaux croissent en conséquence et se répartissent en couches ou strates horizontales, en fonction de leurs dimensions granulométriques. Les grosses fractions granulométriques progressent vers le bas du lit et sont évacuées périodiquement par un conduit de soutirage 5. L'eau mère de la cristallisation parvenant dans le ciel de la chambre 2 est une solution aqueuse saturée (ou légèrement sursaturée) en chlorure de sodium. Elle est recyclée dans le réchauffeur 8, via le conduit 9, où elle est additionnée d'un complément de solution aqueuse saturée de chlorure de sodium, par l'intermédiaire d'une tubulure 18. Le complément de solution aqueuse de chlorure de sodium est réglé pour compenser la quantité de chlorure de sodium qui a cristallisé dans le lit 14 et la quantité d'eau évacuée par l'évaporation dans la chambre de détente 7.

Pendant l'exploitation de l'installation, de la manière décrite ci-dessus, le distributeur 12 est chauffé de manière que sa paroi en contact avec la solution soit à une température qui est supérieure à la température de la solution sursaturée dans la zone 3, en amont du distributeur 12. On évite de la sorte une cristallisation parasite sur le distributeur. Des informations concernant la construction et le chauffage du distributeur 12 sont décrites dans le document EP-A-0352847 (SOLVAY & Cie).

Dans l'installation de la figure 1, le débit de solution dérivé par le tuyau 22 est réglé par un choix approprié des dimensions du tuyau. En variante, on peut monter sur le tuyau 22 une vanne d'ouverture réglable. Le tuyau 22 doit par ailleurs être calorifugé pour éviter que la solution sursaturée de chlorure de sodium qui y circule y subisse un refroidissement suivi d'une cristallisation parasite. Au besoin, le tuyau doit être chauffé. Le courant de solution dérivé par le tuyau 22 a pour fonction d'évacuer de la chambre 3, les cristaux parasites qui viendraient à s'y accumuler. A cet effet, le tuyau 22 débouche dans une zone de la chambre 3, où existe un risque de cristallisation parasite. Au besoin, on peut prévoir plusieurs tuyaux débouchant dans des zones distinctes de la chambre 3.

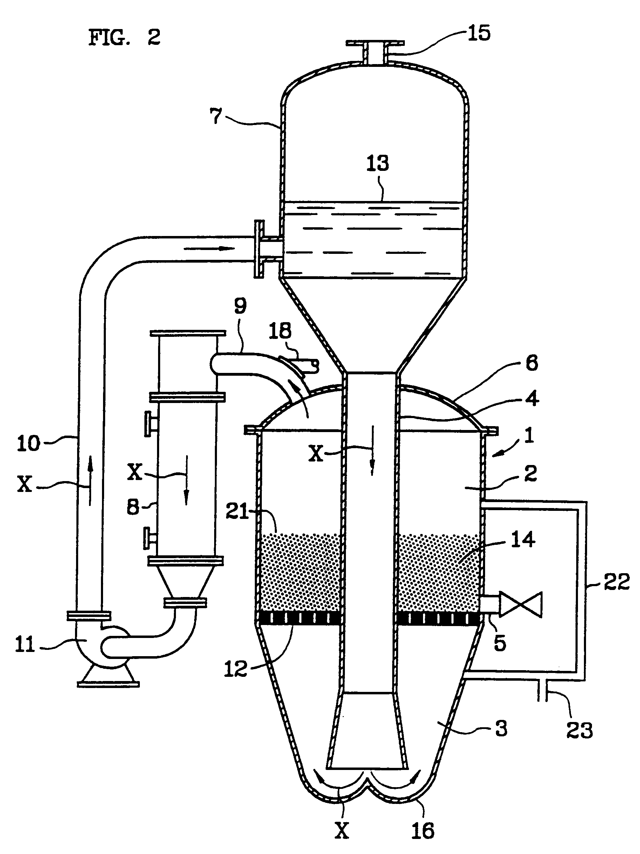

Dans l'installation représentée à la figure 2, le tuyau 22 débouche dans la chambre 2, au-dessus de la surface libre 21 du lit fluidisé 14. Un conduit 23 débouchant dans le tuyau 22 sert à y envoyer une quantité contrôlée d'eau dans le but de désursaturer la fraction de solution sursaturée transitant dans le tuyau 22.

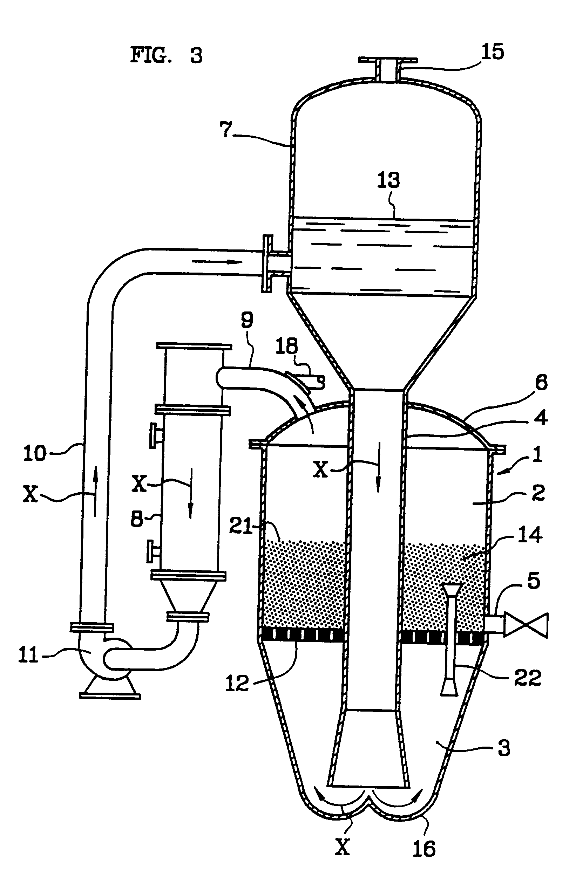

Dans la forme de réalisation représentée à la figure 3, le tuyau 22 est localisé à l'intérieur de l'enceinte 1 et traverse la grille 12. Son extrémité inférieure est de préférence évasée et débouche au voisinage d'une zone de la paroi de la chambre inférieure 3, où existe un risque d'une cristallisation parasite. L'extrémité supérieure du tuyau est de préférence évasée et débouche dans le lit fluidisé 14. Cette forme de réalisation présente l'avantage que le tuyau 22 est maintenu à la température règnant à l'intérieur de l'enceinte 1, ce qui réduit le risque d'une cristallisation parasite à l'intérieur du tuyau. L'installation comprend avantageusement plusieurs tuyaux 22 traversant la grille 12 est répartis uniformément dans l'enceinte 1.

## Revendications

1. Procédé pour la cristallisation d'une substance minérale dans un lit fluidisé de cristaux, que l'on génère en soumettant une solution sursaturée en la substance à cristalliser à une circulation ascendante à travers un distributeur de réacteur à lit fluidisé, situé sous le lit, on recueille l'eau mère de la cristallisation à la sortie du lit et on la sursature pour reconstituer la solution sursaturée précitée, caractérisé en ce qu'on dérive une fraction de la solution sursaturée en amont du distributeur et on la recycle en aval du distributeur, avant de recueillir l'eau mère.

2. Procédé selon la revendication 1, caractérisé en ce qu'on recycle la fraction de solution sursaturée dans le lit.

3. Procédé selon la revendication 1, caractérisé en ce qu'on recycle la fraction de solution sursaturée dans l'eau mère en aval du lit, après l'avoir désursaturée.

4. Procédé selon l'une quelconque des revendications 1 à 3, caractérisé en ce que la fraction de solution sursaturée que l'on dérive est le siège d'une cristallisation parasite.

5. Procédé selon l'une quelconque des revendications 1 à 4, caractérisé en ce que le débit de la fraction de solution sursaturée est compris entre 1 et 10 % du débit de la solution sursaturée qui traverse le distributeur.

6. Procédé selon l'une quelconque des revendications 1 à 5, caractérisé en ce que, pour dériver et recycler la fraction de solution sursaturée, on la fait circuler dans au moins un tuyau traversant le distributeur.

7. Procédé selon l'une quelconque des revendications 1 à 6, caractérisé en ce qu'on met en oeuvre un lit de cristaux de chlorure de sodium et une solution aqueuse sursaturée de chlorure de sodium.

8. Installation pour la cristallisation d'une substance minérale selon le procédé conforme à l'une quelconque des revendications 1 à 7, comprenant une enceinte tubulaire verticale (1), un tube vertical (4) disposé axialement dans l'enceinte tubulaire et débouchant à proximité du fond (16) de celle-ci de manière à délimiter une chambre annulaire (2, 3) dans l'enceinte (1), un dispositif (7) d'alimentation d'une solution sursaturée en la substance à cristalliser, raccordé à l'extrémité supérieure du tube (4), un distributeur (12) de réacteur à lit fluidisé dans la chambre annulaire qu'il divise en une chambre inférieure (3) d'admission de la solution sursaturée et une chambre supérieure (2) de cristallisation constituant le réacteur à lit fluidisé, et un conduit d'évacuation (9) d'une eau mère de la cristallisation, joignant la chambre de cristallisation (2) au dispositif d'alimentation (7), caractérisée en ce qu'elle comprend au moins un tuyau (22) joignant la chambre inférieure d'admission (3) à la chambre supérieur de cristallisation (2), en dérivation sur le distributeur.

9. Installation selon la revendication 8, caractérisée en ce que le tuyau (22) est disposé à l'intérieur de la chambre annulaire (2, 3) et traverse le distributeur (12).

10. Installation selon la revendication 9, caractérisée en ce que l'extrémité inférieure du tuyau (22) est située contre la paroi de l'enceinte tubulaire (1), qui est tronconique dans la chambre inférieure d'admission (3), et l'extrémité supérieure du tuyau (22) débouche dans la chambre de cristallisation (2), au-dessous du niveau supérieure (21) du lit fluidisé (14).

## Patentansprüche

1. Verfahren zum Kristallisieren einer mineralischen Substanz in einem Wirbelbett von Kristallen, das man erzeugt, indem man eine übersättigte Lösung aus der zu kristallisierenden Substanz einem aufsteigenden Umlauf durch einen unter dem Bett gelegenen Wirbelbettreaktorverteiler unterwirft, die Mutterlauge der Kristallisation am Ausgang des Bettes auffängt und sie übersättigt, um die vorgenannte übersättigte Lösung wiederherzustellen, dadurch gekennzeichnet, daß man einen Teil der übersättigten Lösung in Strömungsrichtung vor dem Verteiler ableitet und ihn vor dem Auffangen der Mutterlauge in Strömungsrichtung hinter dem Verteiler zurückführt.

2. Verfahren nach Anspruch 1, dadurch gekennzeichnet, daß man den Teil der übersättigten Lösung in das Bett zurückführt.

3. Verfahren nach Anspruch 1, dadurch gekennzeichnet, daß man den Teil der übersättigten Lösung in Strömungsrichtung hinter dem Bett in die Mutterlauge zurückführt, bevor man diese aus der Übersättigung gebracht hat.

4. Verfahren nach einem beliebigen der Ansprüche 1 bis 3, dadurch gekennzeichnet, daß der Teil der übersättigten Lösung, den man abzieht, Ort einer parasitären Kristallisation ist.

5. Verfahren nach einem beliebigen der Ansprüche 1 bis 4, dadurch gekennzeichnet, daß die Menge des Teils der übersättigten Lösung zwischen 1 und 10 % der Menge der übersättigten Lösung enthalten ist, welche den Verteiler durchsetzt.

6. Verfahren nach einem beliebigen der Ansprüche 1 bis 5, dadurch gekennzeichnet, daß man zum Ableiten und Zurückführen des Teils der übersättigten Lösung diesen in mindestens einem den Verteiler durchsetzenden Rohr umlaufen läßt.

7. Verfahren nach einem beliebigen der Ansprüche 1 bis 6, dadurch gekennzeichnet, daß man ein Bett von Kristallen aus Natriumchlorid und eine übersättigte wäßrige Natriumchloridlösung verwendet.

8. Einrichtung zum Kristallisieren einer mineralischen Substanz nach dem Verfahren gemäß einem beliebigen der Ansprüche 1 bis 7, umfassend eine rohrförmige vertikale Hülle (1), ein vertikales Rohr (4), welches axial in der rohrförmigen Hülle angeordnet ist und in der Nähe von deren Boden (16) mündet, so daß in der Hülle (1) eine ringförmige Kammer (2, 3) begrenzt wird, eine mit dem oberen Ende des Rohrs (4) verbundene Zuführvorrichtung (7) für eine übersättigte Lösung aus der zu kristallisierenden Substanz, einen Wirbelbettreaktorverteiler (12) in der ringförmigen Kammer, welche er in eine untere Zuführkammer (3) für die übersättigte Lösung und in eine den Wirbelbettreaktor bildende obere Kristallisationskammer (2) unterteilt, und eine die Kristallisationskammer (2) mit der Zuführvorrichtung (7) verbindende Auslaßleitung (9) für eine Muttterlauge der Kristallisation, dadurch gekennzeichnet, daß sie mindestens ein Rohr (22) umfaßt, das die untere Zuführkammer (3) unter Umgehung des Verteilers mit der oberen Kristallisationskammer (2) verbindet.

9. Einrichtung nach Anspruch 8, dadurch gekennzeichnet, daß das Rohr (22) im Inneren der ringförmigen Kammer (2, 3) angeordnet ist und den Verteiler (12) durchsetzt.

10. Einrichtung nach Anspruch 9, dadurch gekennzeichnet, daß das untere Ende des Rohrs (22) gegen die Wand der rohrförmigen Hülle (1) zu gelegen ist, die in der unteren Zuführkammer (3) kegelstumpfförmig ist, und das obere Ende des Rohrs (22) unterhalb des oberen Pegels (21) des Wirbelbettes (14) in die Kristallisationskammer (2) mündet.

## Claims

1. Process for crystallizing an inorganic substance in a fluidized bed of crystals, which is generated by subjecting a solution supersaturated in the substance to be crystallized to an ascending circulation across a distributor, located below the bed, of a fluidized-bed reactor, the mother liquor from the crystallization being collected at the bed exit and being supersaturated to reconstitute the said supersaturated solution, characterized in that a fraction of the supersaturated solution is diverted upstream of the distributor and recycled to a point downstream of the distributor, before the mother liquor is collected.

2. Process according to Claim 1, characterized in that the fraction of supersaturated solution is recycled into the bed.

3. Process according to Claim 1, characterized in that the fraction of supersaturated solution is recycled into the mother liquor downstream of the bed, after the former has been desupersaturated.

4. Process according to any one of Claims 1 to 3, characterized in that the fraction of supersaturated solution diverted is the location of a parasitic crystallization.

5. Process according to any one of Claims 1 to 4, characterized in that the flow rate of the fraction of supersaturated solution is between 1 and 10 % of the flow rate of the supersaturated solution passing through the distributor.

6. Process according to any one of Claims 1 to 5, characterized in that, for diverting and recycling the fraction of supersaturated solution, the latter is caused to circulate in at least one pipe passing through the distributor.

7. Process according to any one of Claims 1 to 6, characterized in that a bed of sodium chloride crystals and a supersaturated aqueous solution of sodium chloride are used.

8. Equipment for crystallizing an inorganic substance by the process according to any one of Claims 1 to 7, comprising a vertical tubular shell (1), a vertical tube (4) disposed axially in the tubular shell and having its outlet near the bottom (16) thereof, thus forming an annular chamber (2, 3) in the shell (1), a device (7) for feeding a solution supersaturated in the substance to be crystallized and connected to the upper end of the tube (4), a distributor (12) for a fluidized-bed reactor in the annular chamber which is divided by the distributor into a bottom inlet chamber (3) for the supersaturated solution and a top crystallization chamber (2) constituting the fluidized-bed reactor, and an extraction line (9) for a mother liquor from the crystallization, which line connects the crystallization chamber (2) to the feed device (7), characterized in that it comprises at least one pipe (22) which connects the bottom inlet chamber (3) to the top crystallization chamber (2), bypassing the distributor.

9. Equipment according to Claim 8, characterized in that the pipe (22) is disposed in the interior of the annular chamber (2, 3) and passes through the distributor (12).

10. Equipment according to Claim 9, characterized in that the lower end of the pipe (22) is located against the wall of the tubular shell (1) which is frustoconical in the bottom inlet chamber (3), and the upper end of the pipe (22) opens into the crystallization chamber (2) below the top level (21) of the fluidized bed (14).
